# EUROPEAN PATENT APPLICATION

(11) **EP 1 557 873 A1**
(43) Date of publication of application: **27.07.2005**
(21) Application number: 03769959.2
(22) Date of filing: 29.10.2003
(51) Int. Cl.: H01L 21/205, C23C 16/52

(54) **HEAT TREATING SYSTEM AND HEAT TREATING METHOD**

(30) Priority: 30.10.2002 JP 2002316377
(71) Applicant: TOKYO ELECTRON LIMITED, Minato-ku, Tokyo 107-8481 (JP)
(72) Inventor: FUJITA, Takehiko, Tokyo Electron Limited, Minato-ku, Tokyo 107-8481 (JP); OKADA, Mitsuhiro, Tokyo Electron Limited, Minato-ku, Tokyo 107-8481 (JP); UMEZAWA, Kota, Tokyo Electron Limited, Minato-ku, Tokyo 107-8481 (JP); HASEBE, Kazuhide, Tokyo Electron Limited, Minato-ku, Tokyo 107-8481 (JP); SAKAMOTO, Koichi, Tokyo Electron Limited, Minato-ku, Tokyo 107-8481 (JP)
(74) Representative: Liesegang, Eva
(86) International application number: PCT/JP2003/013849
(87) International publication number: WO 2004/040632

(57) **Abstract**

A thermal processing unit of the present invention includes: a holder that holds a plurality of substrates; a reaction container into which the holder is conveyed; a process-gas supplying mechanism that supplies a process gas into the reaction container; and a heating mechanism that heats the reaction container to conduct a film-forming process to the substrates when the process gas is supplied. Flow-rate-parameter table-data associating number-data of the substrates to be processed by one batch-process with target-data of flow-rate parameter of the process gas is stored in a flow-rate-parameter table-data storing part. A controlling unit obtains target-data of flow-rate parameter of the process gas, depending on an actual number of the substrates to be processed by one batch-process, based on the flow-rate-parameter table-data stored in the flow-rate-parameter table-data storing part, and controls the process-gas supplying mechanism according to the obtained target-data. The target-data of flow-rate parameter are determined in such a manner that a speed of the film-forming process is uniform among a plurality of batch-processes in which the numbers of substrates to be processed are different from each other.

## Description

### TECHNICAL FIELD

The present invention relates to a batch type of thermal processing unit and a thermal processing method wherein a large number of substrates such as semiconductor wafers are thermally processed at one time.

### BACKGROUND ART

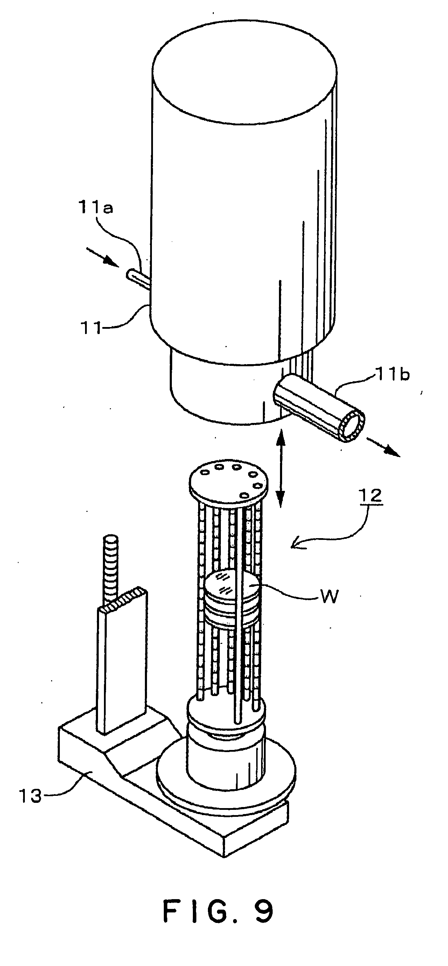

As a batch type of thermal processing unit that conducts a thermal process such as a film-forming process or an oxidizing process to a large number of semiconductor wafers at one time, a vertical type of thermal processing unit is known. Such unit comprises a vertical heating furnace 11 and a wafer boat 12 as a wafer holder, as shown in Fig. 9. The wafer boat 12 is configured to hold a large number of wafers W at a predetermined pitch in a tier-like manner. The wafers W are conveyed onto the wafer boat 12 via a wafer conveying mechanism not shown. Then, the wafer boat 12 is conveyed into the heating furnace 11 by means of a boat elevator 13, and a predetermined thermal process is conducted to the wafers W.

In the above thermal processing unit, for example depending on a kind or a thickness of thin film to be formed, a process pressure, a process temperature, a gas flow rate and so on (target-data of process parameter) are determined. A plurality of recipes is prepared, in which the respective process conditions are written. Then, an operator selects one recipe, so that the thermal processing unit is operated based on a process condition predetermined in advance correspondingly to the recipe. The recipes (process conditions) are made by actually conducting thermal processes to wafers W fully held on the wafer boat 12 and finding out an optimum process condition.

Herein, recently, many-kind small-amount production such as system LSI production has been increased compared with few-kind large-amount production such as DRAM production.

For the few-kind large-amount production, the vertical type of thermal processing unit can have high throughput by conducting a full batch process when a predetermined number of wafers to undergo the same process are prepared. However, for the many-kind small-amount production, it will take a long time for a predetermined number of wafers to undergo the same process to be prepared, so that it is difficult to obtain a merit of high throughput by the batch process.

On the other hand, when a thermal process with the same process parameters is conducted to different numbers of wafers, characteristics of films may be different depending on the number of wafers. For example, when a film-forming process with the same parameters as to a large number of wafers is conducted to a small number of wafers, a speed of the film-forming, uniformity within a surface of film or the like may be changed. In order to avoid the above problem, there is a method of: preparing dummy wafers in addition to product wafers; loading the dummy wafers for a shortfall of the product wafers; and conducting a thermal process with a normal process condition for full wafers.

However, the dummy wafers are expensive. In addition, although the dummy wafers are washed after a plurality of processes to be repeatedly used, the number of repeatedly uses has a limit. That is, after a predetermined number of uses, the dummy wafers have to be replaced with new ones. This increases running cost. In particular, if the wafers have large diameters, for example, since 300 mm wafers are much more expensive than 200 mm wafers, 300 mm dummy wafers are also much expensive. In addition, if the number of product wafers is smaller, it will take a longer time for the dummy wafers to be loaded, which may deteriorate the through put.

### DISCLOSURE OF THE INVENTION

Accordingly, it is an object of the present invention to solve the aforesaid problems and to provide a thermal processing unit and a thermal processing method wherein substrates are thermally processed in a batch manner and wherein film qualities of thin films are uniform among a plurality of batch processes, independently from a number of substrates to be processed by one batch.

The present invention is a thermal processing unit comprising: a holder that holds a plurality of substrates; a reaction container into which the holder is conveyed; a process-gas supplying mechanism that supplies a process gas into the reaction container; a heating mechanism that heats the reaction container to conduct a film-forming process to the substrates when the process gas is supplied; a flow-rate-parameter table-data storing part that stores flow-rate-parameter table-data associating number-data of the substrates to be processed by one batch-process with (a plurality of sets of) target-data of flow-rate parameter of the process gas; and a controlling unit that obtains (selects) (one set of) target-data of flow-rate parameter of the process gas, depending on an actual number of the substrates to be processed by one batch-process, based on the flow-rate-parameter table-data stored in the flow-rate-parameter table-data storing part, and that controls the process-gas supplying mechanism according to the obtained (one set of) target-data; wherein the (plurality of sets of) target-data of flow-rate parameter are determined in such a manner that a speed of the film-forming process is uniform among a plurality of batch-processes in which the numbers of substrates to be processed are different from each other.

According to the present invention, when a thermal process is conducted to the substrates in a batch manner, the thermal process is not always conducted under a condition wherein the holder fully holds the substrates, but the thermal process may be conducted according to the target-data of flow-rate parameter of the process gas corresponding to the number of substrates to be processed by one batch-process. Thus, even if the number of substrates to be processed by one batch-process is smaller than the number corresponding to a full-loading state, the thermal process can be conducted without filling the holder with some dummy wafers. That is, dummy wafers for fully loading become unnecessary, which reduces cost. In addition, the target-data of flow-rate parameter are determined in such a manner that a speed of the film-forming process is uniform among a plurality of batch-processes in which the numbers of substrates to be processed are different from each other. Thus, film qualities of thin films may be uniform among the respective batch processes, independently from the number of substrates to be processed by one batch.

Preferably, the difference between a minimum value and a maximum value of average film-thicknesses of thin films formed on the substrates by the respective batch-processes divided by respective processing times is 0.05 nm / min.

For example, if the process gas includes one kind of gas, the flow-rate parameter may be a flow rate of the process gas. If the process gas includes a film-forming gas that directly serves for the film-forming process and a carrier gas, the flow-rate parameter may be a total flow rate of the both gases with a constant proportion of the both gases, or a proportion of the both gases, or a total flow rate of and a proportion of the both gases. Herein, the film-forming gas is not limited to a film-forming gas for conducting a CVD process. For example, the film-forming gas may correspond to an oxidizing gas when an oxide film is formed by oxidizing a surface of a silicon wafer. In addition, when a plurality of kinds of film-forming gases is used as the process gas like an embodiment described below, the flow-rate parameter may be a total flow rate of the film-forming gases with a constant proportion of the film-forming gases, or a proportion of the film-forming gases, or a total flow rate of and a proportion of the film-forming gases.

For example, the flow-rate-parameter table-data may be made based on experimental data showing relationship between the number-data of the substrates to be processed by one batch-process and the (plurality of sets of) target-data of flow-rate parameter of the process gas. In the case, preferably, the flow-rate-parameter table-data may be made by interpolating the experimental data showing relationship between the number-data of the substrates to be processed by one batch-process and the (plurality of sets of) target-data of flow-rate parameter of the process gas.

In addition, preferably, the heating mechanism has a plurality of heating units which correspond to a plurality of zones in the processing container; a temperature table-data storing part that stores temperature table-data associating the number-data of the substrates to be processed by one batch-process with (a plurality of sets of) target-data of temperature of the respective zones is provided; and the controlling part is adapted to obtain (select) (one set of) target-data of temperature of the respective zones, depending on the actual number of the substrates to be processed by one batch-process, based on the temperature table-data stored in the temperature table-data storing part, and to control the heating units according to the obtained (one set of) target-data.

In addition, preferably, an arrangement table-data storing part that stores arrangement table-data associating the number-data of the substrates to be processed by one batch-process with (a plurality of sets of) arrangement-data of the substrates on the holder is provided; and the controlling part is adapted to obtain (select) (one set of) arrangement-data, depending on the actual number of the substrates to be processed by one batch-process, based on the arrangement table-data stored in the arrangement table-data storing part, and to cause the holder to hold the substrates according to the obtained (one set of) arrangement-data.

In addition, preferably, provided is an adjusting unit that adjusts a flow rate of the process gas based on both the film-forming speed and a change of the film-forming speed per unit flow rate of the process gas, when the film-forming speed is out of a predetermined allowable range.

In addition, the present invention is a thermal processing method using a thermal processing unit including: a holder that holds a plurality of substrates; a reaction container into which the holder is conveyed; a process-gas supplying mechanism that supplies a process gas into the reaction container; and a heating mechanism that heats the reaction container to conduct a film-forming process to the substrates when the process gas is supplied; the thermal processing method comprising: a step of obtaining (selecting) (one set of) target-data of flow-rate parameter of the process gas, depending on an actual number of the substrates to be processed by one batch-process, based on flow-rate-parameter table-data associating number-data of the substrates to be processed by one batch-process with (a plurality of sets of) target-data of flow-rate parameter of the process gas; and a step of controlling the process-gas supplying mechanism according to the obtained target-data of flow-rate parameter of the process gas; wherein the target-data of flow-rate parameter are determined in such a manner that a speed of the film-forming process is uniform among a plurality of batch-processes in which the numbers of substrates to be processed are different from each other.

According to the present invention, when a thermal process is conducted to the substrates in a batch manner, the thermal process is not always conducted under a condition wherein the holder fully holds the substrates, but the thermal process is conducted according to the target-data of flow-rate parameter of the process gas corresponding to the number of substrates to be processed by one batch-process. Thus, even if the number of substrates to be processed by one batch-process is smaller than the number corresponding to a fully-loading state, the thermal process can be conducted without filling the holder with some dummy wafers. That is, dummy wafers for fully loading become unnecessary, which reduces cost. In addition, the target-data of flow-rate parameter are determined in such a manner that a speed of the film-forming process is uniform among a plurality of batch-processes in which the numbers of substrates to be processed are different from each other. Thus, film qualities of thin films may be uniform among the respective batch processes, independently from the number of substrates to be processed by one batch.

Preferably, the difference between a minimum value and a maximum value of average film-thicknesses of thin films formed on the substrates by the respective batch-processes divided by respective processing times is 0.05 nm / min.

In addition, preferably, the heating mechanism has a plurality of heating units which correspond to a plurality of zones in the processing container, and the thermal processing method further comprises: a step of obtaining (selecting) (one set of) target-data of temperature of the respective zones, depending on the actual number of the substrates to be processed by one batch-process, based on temperature table-data associating the number-data of the substrates to be processed by one batch-process with (a plurality of sets of) target-data of temperature of the respective zones; and a step of controlling the heating units according to the obtained target-data of temperature of the respective zones.

### BRIEF DESCRIPTION OF THE DRAWINGS

Fig. 1 is a perspective view showing the whole schematic structure of a thermal processing unit according to an embodiment of the present invention;
Fig. 2 is a vertical sectional view showing a heating furnace and its vicinities of the thermal processing unit of Fig. 1;
Fig. 3 is an explanatory view showing a control system of the thermal processing unit of Fig. 1;
Fig. 4 is a graph showing a film-forming speed, overlapping with a relationship between batch sizes and target-data of a gas flow rate;
Fig. 5 is an explanatory view showing data associating batch sizes with temperature target-data of respective zones;
Fig. 6 is an explanatory view showing an example of arrangement layout of wafers on a wafer boat;
Fig. 7 is a flow chart for explaining an operation of the embodiment;
Fig. 8 is an explanatory view showing a control system according to another embodiment of the present invention; and
Fig. 9 is a schematic perspective view showing a conventional thermal processing unit.

### BEST MODE FOR CARRYING OUT THE INVENTION

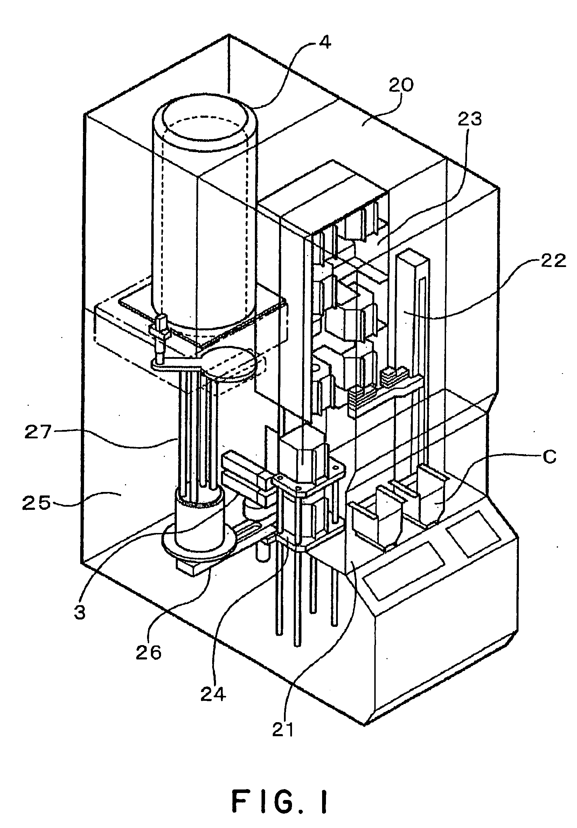

Hereinafter, as an embodiment of a thermal processing unit according to the present invention, a vertical type of thermal processing unit that conducts a film-forming process is explained. At first, the whole structure of the vertical type of thermal processing unit is simply explained with reference to Fig. 1. In Fig. 1, 20 represents a housing as an outside part of the unit, 21 represents a carrier conveying-in and conveying-out part, 22 represents a carrier conveying mechanism, 23 represents a carrier stocker, and 24 represents a delivery stage. When a carrier C containing semiconductor wafers as substrates (omitted in Fig. 1) is conveyed at the carrier conveying-in and conveying-out part 21, the carrier C is conveyed to the carrier stocker 23 by the carrier conveying mechanism 22, and stocked therein temporarily. Then, the carrier C is adapted to be conveyed to the delivery stage 24 at a suitable time. In addition, a wafer conveying unit 3 provided in a wafer loader room 25 is adapted to take out a wafer W from the carrier C on the delivery stage 24, and to convey the wafer W onto a wafer boat 27 as a holder provided on a boat elevator 26. In addition, the wafer boat 27 is adapted to be moved up by the boat elevator 26, and to be loaded in a heating furnace 4.

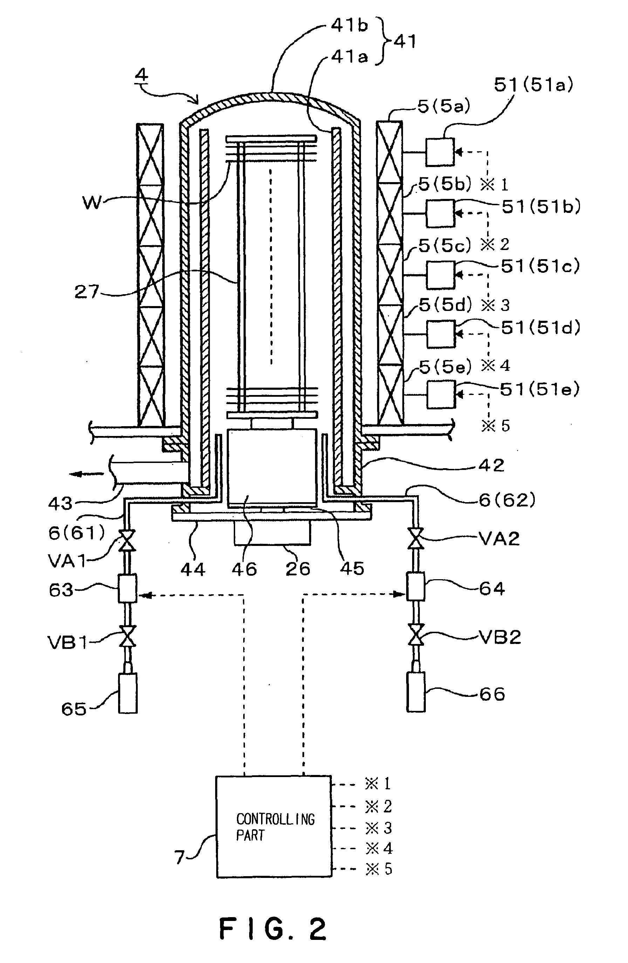

Herein, the heating furnace 4 and its vicinities are explained in detail with reference to Fig. 2. As shown in Fig. 2, the heating furnace 4 includes a reaction tube 41 made of transparent quartz and having a double-tube structure consisting of: an inner tube 41a whose both ends are open, and an outer tube 41b whose upper end is closed. Heaters 5, for example consisting of resistance heaters, are provided so as to surround the reaction tube 41, as a heating unit. Thermal processing atmosphere in the reaction tube 41 is divided into a plurality of zones in a vertical direction. The heaters 5 are separately provided for the respective zones (5a to 5e) in such a manner that a heating control can be conducted independently for each zone. The zone heaters 5a to 5e are structured in such a manner that their temperatures are respectively controlled by control signals from a temperature controller 51 (51a to 51e).

Lower parts of the inner tube 41a and the outer tube 41b are supported by a cylindrical manifold 42. A plurality of gas supplying pipes 6 is connected to the manifold 42 in such a manner that supplying ports thereof are opened at a lower area in the inner tube 41a. In Fig. 2, for the convenience of drawing, two gas supplying pipes 6 (61, 62) are shown. Gas supplying sources 65, 66 are connected to the gas supplying pipes 61, 62 via valves VA1, VA2, flow-rate adjusting units 63, 64 such as mass flow controllers, and valves VB1, VB2. In this example, the gas supplying sources 65, 66 are respectively supplying sources of a dichlorosilane gas and a ammonia gas, which are process gases.

In addition, a gas-discharging pipe 43 whose one end is connected to a vacuum pump not shown is connected to the manifold 42 in order to discharge gas through between the inner tube 41a and the outer tube 41b. In this example, the inner tube 41a, the outer tube 41b and the manifold 42 form a reaction container. A lower open part of the manifold 42 is adapted to be closed by a lid 44, which is provided at an upper end of the boat elevator 26. A turn table 45 that can be turned (rotated) by a driving part not shown and a heat-retaining unit 46 supported by the turn table 45 are interposed between the lid 44 and the wafer boat 27.

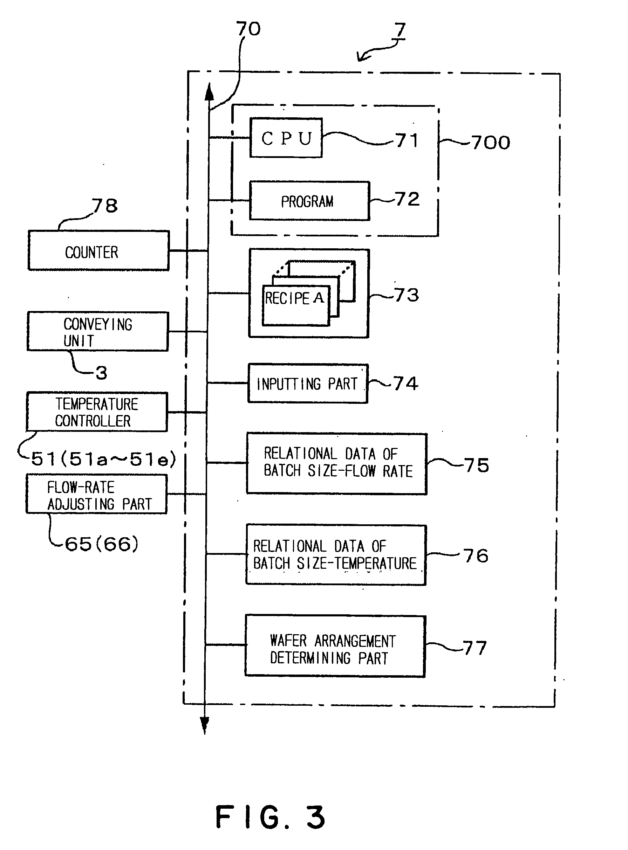

The vertical thermal processing unit comprises a controlling part 7. The controlling part 7 is configured to send signals corresponding to temperature target-values as control signals to the temperature controller 51 (51a to 51e), and to send signals corresponding to flow-rate target-values as control signals to the flow-rate adjusting units 63, 64. A structure of the controlling unit 7 is explained in more detail with reference to Fig. 3. In Fig. 3, 70 represents bass lines, 71 represents a CPU (central processing unit), 72 is a program storing part, 73 represents a recipe storing part, 74 is an inputting part. A program for reading out data from a storing part described below or for processing the data is stored in the program storing part 72. In this example, the CPU 71 and the program storing part 72 form a processing unit (a controlling unit) for reading out data described below and for making the control signals. In the recipe storing part 73, for each kind of thin film to be formed, a recipe is stored, in which temperature adjustment of the heaters 5, on-off adjustment of the valve VA1 and so son in the gas supplying pipes 6, pressure adjustment, and other processing procedures are written. The inputting part 74 has an operational panel and a keyboard, which are operated by an operator. The recipe is selected via the inputting part 74.

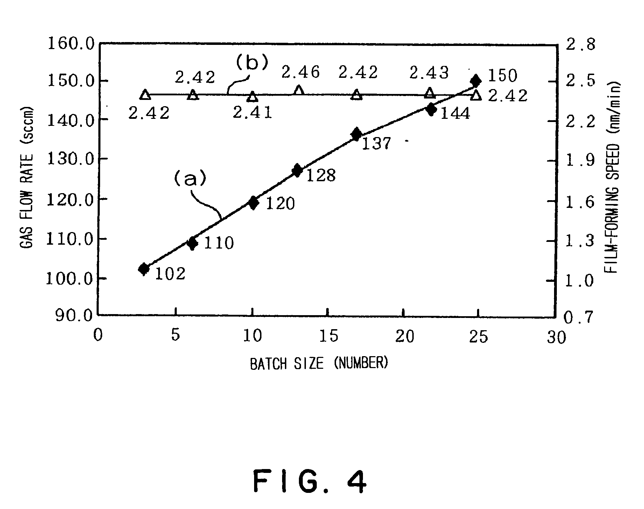

In addition, in Fig. 3, 75 represents a first storing part that stores relational data of batch sizes and flow rates. The batch size means a number of product wafers held on the wafer boat at a thermal process of one batch. Herein, the flow rate is an example of flow-rate parameter, and the total flow rate of the dichlorosilane gas and the ammonia gas, which are process gases. Then, the relational data of batch sizes and flow rates are table data in which gas flow rates suitable for the respective batch sizes are written. For example, when the number of product wafers is 25 for a full loading state, a gas flow rate suitable for each of 1 to 25 is written therein. The data are made based on a graph (a) in Fig. 4.

In the graph (a), the batch size was set at 3, 6, 10, 13, 17, 22 and 25. In the respective batch sizes, a proportion of the dichlorosilane gas and the ammonia gas was constant (common), but the total flow rate was adjusted. Thicknesses of silicon nitride films formed by the thermal processes were measured, film-forming speeds were calculated by dividing the thicknesses by respective process times, and the total flow rates that make the film-forming speeds uniform were plotted. In Fig. 4, the film-forming speeds corresponding to the respective batch sizes are written as a graph (b). From the graph (b), it may be understood that the film-forming speeds are made uniform by setting the flow rate according to the graph (a). For example, when the batch size is 10, that is, when ten wafers are processed, if the flow rate is set at 120 sccm, a target film-forming speed may be achieved.

Herein, a value of film-thickness in each batch size is an average film-thickness obtained from an experimental wafer arranged in an area for a product wafer. In addition, for example, the total flow rate for making the film-forming speeds of the respective batch sizes uniform is such that the difference between a minimum value and a maximum value of the film-forming speeds of the respective batch-processes is not more than 0.05 nm / min. The inventor thinks that film qualities of thin films formed in the respective batch sizes are uniform, that is, film qualities of thin films among the batch-processes are uniform, if dispersion of the film-forming speeds is within the range. Actually, from confirmation of film qualities through an SEM (scanning electron microscope), the film qualities were uniform if the difference between a minimum value and a maximum value of the film-forming speeds of the respective batch-processes is not more than 0.05 nm / min.

Fig. 4 shows the data for only seven points. However, data for each batch size are obtained by interpolating the graph (b) of Fig. 4, and inputted into the relational data of batch sizes and flow rates stored in the first storing part 75. Instead, the graph (b) may be stored in the first storing part 75, and the graph may be outputted while interpolated.

Actually, the graph of Fig. 4 is made for each of various thermal process temperatures. Based on that, the relational data of batch sizes and gas flow rates are made for each of various thermal process temperatures, and stored in the first storing part 75.

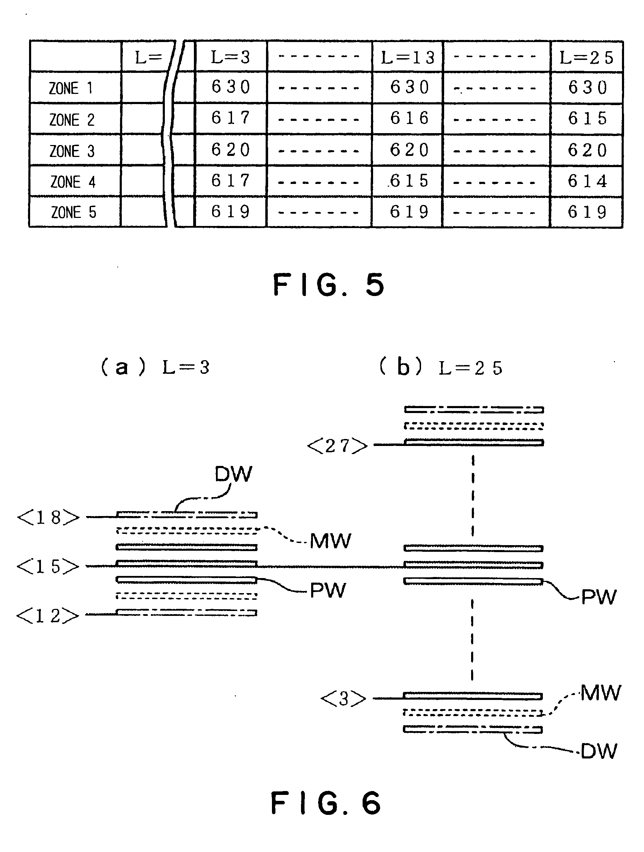

In the present invention, as described above, the film-forming speeds among the respective batch processes may be made uniform by conducting the thermal processes according to the flow rates set for the respective batch sizes. However, if some dispersion remains in the film-forming speeds, depending on the batch size, it is preferable to change the temperature target-values finely. Then, in this example, a second storing part 76 that stores relational data of batch sizes and temperatures is provided in the controlling part 7. The relational data of batch sizes and temperatures are data associating the batch sizes with the temperature target-values of the respective zones 1 to 5 in the reaction container. For example, as shown in Fig. 5, they are table data in which temperature target values of the respective zones 1 to 5 for each of the batch sizes are written. "L" represents a batch size, that is, a number of product wafers in one batch. For the convenience of drawing, specific temperature target values for the cases wherein the number of product wafers is 3 (L = 3), 13 (L = 13) and 25 (L = 25) are shown. However, actually, values for each of 1 to 25 are written. The zones 1 to 5 are areas to be respectively heated by the zone heaters 5a to 5e. In this example, temperature target values for the central zone 3 are the same for each of the batch sizes. For example, when a thermal process temperature of the wafers W (process temperature) is set, a temperature of a product wafer located at a central position among product wafers is controlled to the thermal process temperature. In the embodiment wherein the film-forming speeds are uniform among the different batch sizes, the temperature target value for the central wafer among the wafers is not changed, but other temperature target values for the upper and lower zones are changed finely. In other words, a temperature gradient is finely adjusted.

Herein, the graph (b) of Fig. 4 showing the film-forming speeds in the respective batch sizes was obtained from a result of heating control based on the relational data of batch sizes and flow rates and the relational data of batch sizes and temperatures. However, the present invention doesn't have to adjust the temperature target-values for the respective zones 1 to 5 among the batch sizes, that is, doesn't have to use the relational data of batch sizes and temperatures, if uniformity of the film-forming speeds can be secured by adjusting the flow rates among the respective batch sizes. Alternatively, the relational data of batch sizes and temperatures don't have to be made for each of all the batch sizes. For example, the temperature target values for the respective zones 1 to 5 for only specific batch sizes, for example for only the above seven batch sizes, may be written. In the case, the temperature target values for the respective zones 1 to 5 for the other batch sizes may be obtained by interpolating the written data.

In addition, the controlling part 7 includes a wafer-arrangement determining part 77. The wafer-arrangement determining part 77 is a storing part that stores an algorithm defining how to determine a product-wafer arrangement for each of the batch sizes. For example, when twenty-five product wafers are necessary for a full loading state, the wafer boat 27 has twenty-nine steps of holding grooves (slots), in general. According to the algorithm, the product wafers PW are arranged in such a manner that the central wafer is arranged at the fifteenth uppermost step. Monitor wafers MW are arranged at the upper and lower steps of the product wafers PW. In addition, dummy wafers DW are arranged at the upper and lower steps of the monitor wafers MW. A wafer arrangement wherein the batch size is three (L = 3) and a wafer arrangement wherein the batch size is twenty-five (L = 25) are shown in Fig. 6. The ordinal numbers of steps of the wafer boat 27 are shown in "< >" in Fig. 6. In the example of Fig. 6, the number of the product wafers is odd. If the number of the product wafers is even, for example, the wafer arrangement is determined in such a manner that the number of the product wafers in an area lower than the fifteenth uppermost step is more than the number of the product wafers in an area higher than the fifteenth uppermost step. The dummy wafers DW are arranged in order to facilitate a temperature control in an arrangement area for the product wafers PW. The monitor wafers MW are arranged in order to estimate thin films formed on the product wafers PW by the batch process.

In Fig. 3 again, the controlling part 7 is connected to a counter 81, the conveying unit 3 of the wafers W shown in Fig. 1, the temperature controller 51 (51a to 51e) and the flow-rate adjusting parts 65,66. The counter 81 counts the number of product wafers in the carrier C on the carrier conveying-in and conveying-out part 21, based on a signal from a mapping sensor not shown, which consists of a reflex optical sensor or the like provided in the carrier conveying-in and conveying-out part 21. The controlling part 7 knows where the carrier C should be placed in the carrier stocker 23 and when the thermal process should be conducted. Thus, if the number of product wafers in each carrier is counted at a timing wherein the carrier is conveyed in the carrier conveying-in and conveying-out part 21, the number of product wafers thermally processed at each batch-process is obtained. However, actually, information about the number of product wafers in each conveyed carrier C is sent from a controlling part of the previous step or an upper computer to the vertical type of thermal processing unit. Thus, even if the number of wafers is not counted by the mapping sensor, the number of wafers in each carrier can be obtained. Herein, if both the counting of the wafer and the sent information are used, reliability is higher. In addition, an operator can also input a batch size via the inputting part 74.

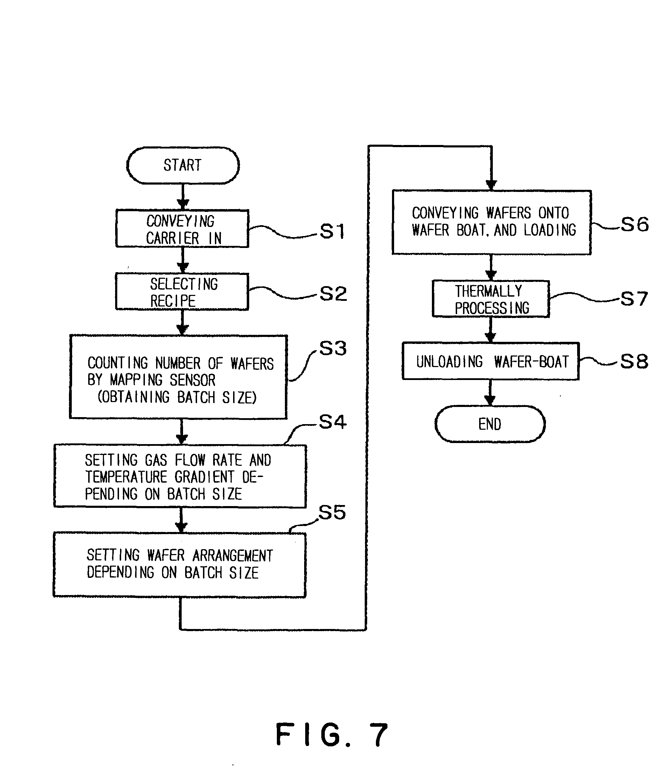

Next, with reference to a flow chart shown in Fig. 7, an operation of the present embodiment is explained. At first, a carrier C is conveyed from the outside into the carrier conveying-in and conveying-out part 21 (STEP S1). Then, depending on a kind of the process, a corresponding recipe is selected from a recipe selecting part 73, via the inputting part 74 (STEP S2). Then, for example as described above, the number of product wafers PW in the carrier C is counted by the counter 78, and information thereof is sent into the controlling part 7. Based on the number information, a batch size to be thermally processed is obtained (STEP S3). The CPU 71 obtains a flow rate of the process gas corresponding to the batch size, taking into consideration the relational data of batch sizes and flow rates stored in the first storing part 75, and obtains a temperature gradient (temperature target-values for the respective zones 1 to 5) corresponding to the batch size, taking into consideration the relational data of batch sizes and temperatures stored in the second storing part 76 (STEP S4).

In addition, the wafer-arrangement determining part 77 determines an arrangement (layout) of the product wafers, the dummy wafers and the monitor wafers, correspondingly to the batch size (STEP S5). The CPU 71 outputs a control signal to a controller not shown, according to the program stored in the program storing part 72, to control the conveying unit 3 so as to achieve the determined arrangement. Thus, the wafers W are conveyed onto the wafer boat 27 (STEP S6). After that, the wafer boat 27 is conveyed into the reaction container by means of the boat elevator 26. Then, the dichlorosilane gas and the ammonia gas are respectively supplied from the process gas supplying pipes 6 (61, 62) into the reaction container under a predetermined process and temperature, so that the thermal process is conducted to the wafers W so as to form silicon nitride films thereon (STEP S7). That is, the thermal process is conducted based on steps and parameter values written in the selected recipe. Thus, regarding the flow rate of the process gas, a control signal is outputted to the flow-rate adjusting parts 65, 66 in such a manner that the flow rate corresponds to the batch size. In addition, in this example, regarding the temperature target-values for the respective zones 1 to 5, a control signal is outputted to the temperature controller 51 (51a to 51e) in such a manner that the temperatures of the heaters 5 (5a to 5e) are controlled to temperatures corresponding to the batch size. Then, after the thermal process for a predetermined time, the wafer boat 27 is conveyed out from the reaction container (STEP S8).

According to the above embodiment, the thermal process is not always conducted under a condition wherein the wafer boat 27 fully holds the wafers W, but the thermal process may be conducted according to the flow-rate parameter (in this example, the target value of the total flow rate) of the process gas corresponding to the number of product wafers to be processed by one batch-process. Thus, dummy wafers for fully loading become unnecessary, which reduces cost. In addition, deterioration of the throughput may be inhibited.

The target-data of flow-rate parameter are determined in such a manner that a speed of the film-forming process is uniform among a plurality of batch-processes in which the numbers of product wafers to be processed are different from each other. Thus, film qualities of thin films may be uniform among the respective batch processes, independently from the number of product substrates to be processed by one batch. That is, if the flow rate is changed, although there is a fear that the film quality is also changed, it can be thought that the film quality may be maintained by changing the flow rate while maintaining the film-forming speed. More specifically, the film-forming speeds are determined by wafer temperatures and gas environment near the wafers. Thus, if the film-forming speeds are uniform under the same temperature nevertheless the flow rate is changed, it can be said that the gas environment near the wafers is the same. In addition, if the wafer temperatures and the gas environment are the same, it can be thought that the film quality of formed thin films is constant. Thus, even if a circuit pattern of a device is made finer and/or thinner, dispersion of characteristics of the device can be inhibited.

In addition, a film thickness per unit flow rate at the above total flow rate, that is, a sensitivity coefficient (nm / sccm) may be obtained in advance, and the film thickness of a monitor wafer may be measured after the thermal process. If the measured thickness is out of an allowable range, the thickness difference may be divided by the sensitivity coefficient to obtain a corresponding increase or decrease of the flow rate, and then the flow rate may be adjusted by the increase or decrease. This is substantially the same as: a film-forming speed per unit flow rate (sensitivity coefficient) at the above total flow rate may be obtained in advance; and if the film-forming speed of an obtained thin film is out of an allowable range, the flow rate may be adjusted based on the difference and the sensitivity coefficient.

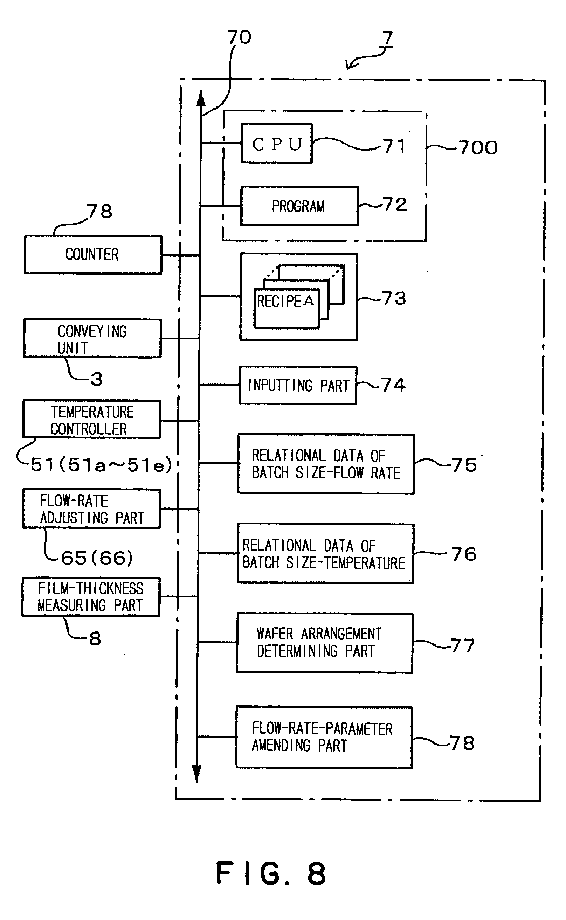

Fig. 8 shows an example of structure of the controlling part 7 to achieve the above procedures. In Fig. 7, a flow-rate-parameter amending part 79 is a part for amending the flow rate based on the above sensitivity coefficient and a difference between an inputted measured film thickness and the allowable film thickness. After the flow rate is amended, the thermal process is conducted with the amended flow rate. In addition, as shown in Fig. 8, it is preferable that the measured film thickness is inputted from a film-thickness measuring part 8 to the controlling part 7 via an on-line. In the case, a step of obtaining the difference between the measured film thickness and the predetermined allowable film thickness; a step of obtaining an amendment for the flow rate based on the sensitivity coefficient; a step of amending the flow rate; and so on may be automatically conducted. It can be thought that the same thin films as those on the product wafers are formed on the monitor wafers. Thus, amending the flow rate based on a measured film thickness of a monitor wafer is equivalent to amending the flow rate based on a measured film thickness of a product wafer. It is possible to amend the flow rate based on a film thickness of a product wafer, instead of a monitor wafer.

In the above description, if two kinds of film-forming gasses are used, the flow-rate parameter is not limited to a total flow rate of the both gases with a constant proportion of the both gases. For example, the flow-rate parameter may be a proportion of the both gases with a constant total flow rate of the both gases, or a total flow rate of and a proportion of the both gases. In addition, if a carrier gas is used, the flow-rate parameter may be a proportion of the carrier gas and the film-forming gas (gases), or a proportion of the film-forming gases with a constant flow rate of the carrier gas, or the like.

In addition, the present invention is not limited to a process for forming a thin film by means of a CVD process or the like, but is applicable to a case for forming an oxide film by oxidizing a silicon film.

## Claims

1. A thermal processing unit comprising:
a holder that holds a plurality of substrates;
a reaction container into which the holder is conveyed;
a process-gas supplying mechanism that supplies a process gas into the reaction container;
a heating mechanism that heats the reaction container to conduct a film-forming process to the substrates when the process gas is supplied;
a flow-rate-parameter table-data storing part that stores flow-rate-parameter table-data associating number-data of the substrates to be processed by one batch-process with target-data of flow-rate parameter of the process gas; and
a controlling unit that obtains target-data of flow-rate parameter of the process gas, depending on an actual number of the substrates to be processed by one batch-process, based on the flow-rate-parameter table-data stored in the flow-rate-parameter table-data storing part, and that controls the process-gas supplying mechanism according to the obtained target-data;
wherein
the target-data of flow-rate parameter are determined in such a manner that a speed of the film-forming process is uniform among a plurality of batch-processes in which the numbers of substrates to be processed are different from each other.

2. A thermal processing unit according to claim 1, wherein
the difference between a minimum value and a maximum value of average film-thicknesses of thin films formed on the substrates by the respective batch-processes divided by respective processing times is 0.05 nm / min.

3. A thermal processing unit according to claim 1 or 2, wherein the flow-rate parameter is a flow rate of the process gas.

4. A thermal processing unit according to claim 1 or 2, wherein
the process-gas supplying mechanism is adapted to supply a plurality of kinds of process gases into the reaction container; and
the flow-rate parameter is at least one of a total flow rate and a proportion of flow rates of the plurality of kinds of process gases.

5. A thermal processing unit according to any of claims 1 to 4, wherein
the flow-rate-parameter table-data are made based on experimental data showing relationship between the number-data of the substrates to be processed by one batch-process and the target-data of flow-rate parameter of the process gas.

6. A thermal processing unit according to claim 5, wherein
the flow-rate-parameter table-data are made by interpolating the experimental data showing relationship between the number-data of the substrates to be processed by one batch-process and the target-data of flow-rate parameter of the process gas.

7. A thermal processing unit according to any of claims 1 to 6, wherein
the heating mechanism has a plurality of heating units which correspond to a plurality of zones in the processing container;
a temperature table-data storing part that stores temperature table-data associating the number-data of the substrates to be processed by one batch-process with target-data of temperature of the respective zones is provided; and
the controlling part is adapted to obtain target-data of temperature of the respective zones, depending on the actual number of the substrates to be processed by one batch-process, based on the temperature table-data stored in the temperature table-data storing part, and to control the heating units according to the obtained target-data.

8. A thermal processing unit according to any of claims 1 to 7, wherein
an arrangement table-data storing part that stores arrangement table-data associating the number-data of the substrates to be processed by one batch-process with arrangement-data of the substrates on the holder is provided; and
the controlling part is adapted to obtain arrangement-data, depending on the actual number of the substrates to be processed by one batch-process, based on the arrangement table-data stored in the arrangement table-data storing part, and to cause the holder to hold the substrates according to the obtained arrangement-data.

9. A thermal processing unit according to any of claims 1 to 8, further comprising
an adjusting unit that adjusts a flow rate of the process gas based on both the film-forming speed and a change of the film-forming speed per unit flow rate of the process gas, when the film-forming speed is out of a predetermined allowable range.

10. A thermal processing method using a thermal processing unit including:
a holder that holds a plurality of substrates;
a reaction container into which the holder is conveyed;
a process-gas supplying mechanism that supplies a process gas into the reaction container; and
a heating mechanism that heats the reaction container to conduct a film-forming process to the substrates when the process gas is supplied;
the thermal processing method comprising:
a step of obtaining target-data of flow-rate parameter of the process gas, depending on an actual number of the substrates to be processed by one batch-process, based on flow-rate-parameter table-data associating number-data of the substrates to be processed by one batch-process with target-data of flow-rate parameter of the process gas; and
a step of controlling the process-gas supplying mechanism according to the obtained target-data of flow-rate parameter of the process gas;
wherein
the target-data of flow-rate parameter are determined in such a manner that a speed of the film-forming process is uniform among a plurality of batch-processes in which the numbers of substrates to be processed are different from each other.

11. A thermal processing method according to claim 10, wherein
the difference between a minimum value and a maximum value of average film-thicknesses of thin films formed on the substrates by the respective batch-processes divided by respective processing times is 0.05 nm / min.

12. A thermal processing method according to claim 10 or 11, wherein
the heating mechanism has a plurality of heating units which correspond to a plurality of zones in the processing container,
the thermal processing method further comprises:
a step of obtaining target-data of temperature of the respective zones, depending on the actual number of the substrates to be processed by one batch-process, based on temperature table-data associating the number-data of the substrates to be processed by one batch-process with target-data of temperature of the respective zones; and
a step of controlling the heating units according to the obtained target-data of temperature of the respective zones.
